Europäisches Patentamt

European Patent Office

Office européen des brevets

(11) Numéro de publication: **0 156 727**
**B1**

(12) **FASCICULE DE BREVET EUROPEEN**

(45) Date de publication du fascicule du brevet:
**01.06.88**

(51) Int. Cl.⁴: **G 01 R 19/165,** H 02 H 3/24

(21) Numéro de dépôt: **85400522.0**

(22) Date de dépôt: **19.03.85**

(54) Dispositif pour la surveillance d'une tension électrique sujette à des interruptions involontaires et momentanées.

(30) Priorité: **23.03.84 FR 8404535**

(43) Date de publication de la demande:
**02.10.85 Bulletin 85/40**

(45) Mention de la délivrance du brevet:
**01.06.88 Bulletin 88/22**

(84) Etats contractants désignés:
**DE GB IT NL**

(56) Documents cités:
**US - A - 4 031 464**
**US - A - 4 156 280**
**US - A - 4 245 150**

(73) Titulaire: **AEROSPATIALE Société Nationale Industrielle, 37, Boulevard de Montmorency, F-75781 Paris Cédex 16 (FR)**

(72) Inventeur: **Jonca, Henri, 30 Bld. Jean Brunhes, F-31300 Toulouse (FR)**
Inventeur: **Cochet, Paul, 14 rue du Petit Barry, F-31270 Cugnaux (FR)**

(74) Mandataire: **Bonnetat, Christian et al, Cabinet PROPI Conseils 23 rue de Léningrad, F-75008 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

ACTORUM AG

### Description

La présente invention concerne un dispositif pour la surveillance d'une tension électrique sujette à des interruptions involontaires et momentanées. Elle peut être mise en œuvre aussi bien pour la surveillance d'une tension électrique continue que pour celle d'une tension électrique alternative.

On sait qu'il est souvent préjudiciable pour un système électrique que son alimentation soit sujette à des interruptions involontaires et momentanées, généralement désignées par le terme de microcoupures. C'est notamment le cas pour les systèmes informatiques. Il est donc particulièrement important que l'on puisse surveiller les alimentations électriques afin de déterminer le nombre et la durée des microcoupures qui ont lieu, et pouvoir en tenir compte et/ou y remédier.

Une interruption momentanée de tension électrique se traduit par une brusque diminution d'amplitude suivie d'un brusque rétablissement. Il est donc relativement aisé de détecter une telle interruption. Par exemple, par le brevet US-A-4245150, on connaît déjà un dispositif pour la surveillance d'une tension électrique sujette à des interruptions involontaires et momentanées et comportant des moyens pour détecter une telle interruption.

Cependant, le signal ainsi détecté n'est par représentatif d'une interruption ou est relativement informe et ne peut être utilisé pour attaquer des dispositifs électroniques d'exploitation.

L'objet de la présente invention est de remédier à cet inconvénient et de réaliser un dispositif délivrant, pour chaque microcoupure (ou tout au moins pour chacune des microcoupures comprises dans une gamme de sensibilité déterminée dudit dispositif), un signal caractéristique de l'interruption et de forme parfaitement rectangulaire pour pouvoir être électroniquement exploité.

A cette fin, selon l'invention, le dispositif pour la surveillance d'une tension électrique sujette à des interruptions involontaires et momentanées, comportant des moyens pour détecter une telle interruption, est caractérisé en ce qu'il comporte des moyens pour élaborer un signal électrique continu dont la durée est représentative de celle de ladite interruption, des premiers moyens pour échantillonner la durée dudit signal électrique au moyen d'une première suite périodique d'impulsions rectangulaires, des seconds moyens pour échantillonner la durée dudit signal électrique au moyen d'une seconde suite périodique d'impulsions rectangulaires, lesdites première et seconde suites périodiques étant telles que les impulsions de chacune d'elles correspondent aux intervalles entre les impulsions de l'autre suite, et des moyens pour additionner les signaux d'échantillonnage apparaissant aux sorties desdits premiers et seconds moyens échantillonnant la durée dudit signal électrique, afin d'obtenir un signal en créneau rectangulaire dont la durée correspond à celle de ladite interruption.

Ainsi, grâce à ce double échantillonnage, on obtient un créneau rectangulaire parfait, fidèlement représentatif de d'interruption de tension correspondante. Le dispositif selon l'invention peut alors comporter des moyens de comptage destinés à compter le nombre des signaux en créneaux rectangulaires, puisque ledit créneau rectangulaire sera susceptible d'actionner lesdits moyens de comptage. Eventuellement, ce créneau rectangulaire pourrait commander un générateur électrique de secours, apte à pallier la défaillance de la tension électrique surveillée.

Afin de connaître la durée desdites microcoupures, il est avantageux que le dispositif conforme à l'invention comporte des troisièmes moyens pour d'échantillonnage des signaux en créneaux rectangulaires et des moyens de comptage destinés à compter la durée de chacun desdits signaux en créneaux rectangulaires.

Par ailleurs, pour permettre le fonctionnement du dispositif selon l'invention, celui-ci comporte de préférence des moyens d'alimentation électrique à batterie tampon pour l'alimentation d'au moins certains des moyens dudit dispositif pendant les interruptions de la tension électrique.

Dans un mode de réalisation avantageux, le dispositif est remarquable en ce que les impulsions de ladite première suite périodique sont identiques entre elles et sont identiques à celles de ladite seconde suite, en ce que dans chaque suite deux impulsions consécutives sont séparées par un intervalle de durée égale à la durée d'une impulsion et en ce que les impulsions de l'une des suites sont déphasées de 180° par rapport à celles de l'autre suite. Ainsi, lesdits premiers et seconds moyens d'échantillonnage peuvent comporter un générateur d'impulsions unique, associé à un inverseur.

Lesdits premiers et seconds moyens d'échantillonnage peuvent comporter des mémoires verrouillables qui sont montées en parallèle à la sortie des moyens élaborant ledit signal électrique continu dont la durée est représentative de celle de ladite interruption et dont les entrées de déclenchement reçoivent respectivement lesdites première et seconde suites périodiques d'impulsions rectangulaires.

Afin d'obtenir une représentation encore plus fidèle de l'interruption de tension par le signal en créneau rectangulaire, il est avantageux que ledit signal électrique continu soumis au double échantillonnage soit soumis à une mise en forme préalable. Aussi, selon une particularité importante de la présente invention, les moyens d'élaboration dudit signal électrique continu dont la durée est représentative de celle de ladite interruption comportent au moins une porte logique à commutation rapide. De plus, il est avantageux que lesdits moyens d'élaboration permettent l'ajuster le seuil de déclenchement de ladite porte logique à commutation rapide.

On conçoit aisément que le dispositif conforme à l'invention permette la surveillance des tensions continues et des tensions alternatives. Toutefois, il est particulièrement utile pour la surveillance de la tension de réseaux d'alimentation alternative susceptibles d'être le siège de microcoupures. Dans ce cas, les moyens d'élaboration du signal électrique continu, dont la durée est représentative de celle de l'interruption, comportent un redresseur, de préférence à double alternance, et un circuit intégrateur, de façon à fournir une tension redressée ondulée, qui comportera une interruption en concordance avec chacune des interruptions apparaissant dans la tension alternative du réseau. Afin de permettre de faire varier la sensibilité de détection du dispositif selon l'invention, il est avantageux que ce circuit intégrateur soit du type à constante de temps réglable. Ainsi, il est possible de déterminer un ou plusieurs seuils de sensibilité et de choisir, par la durée, le type d'interruptions que l'on désire détecter.

Quoique la surveillance de la tension d'un réseau d'alimentation soit l'une des applications les plus intéressantes de la présente invention, il va de soi que le dispositif selon l'invention peut servir à de nombreuses utilisations. Par exemple, ce dispositif peut:

— vérifier de façon permanente le bon fonctionnement d'un onduleur ou de tout autre système de secours connecté à un réseau d'alimentation électrique et ayant en charge d'alimenter régulièrement un système placé en aval;

— vérifier l'alimentation électrique de systèmes embarqués à bord de machines roulantes reliées à un réseau par des frotteurs (caténaires), générateurs de microcoupures perturbant de façon notoire le fonctionnement desdits systèmes;

— contrôler des éléments perturbateurs (moteurs, relais, contacteurs, etc.) connectés à un réseau et susceptibles de perturber la tension de celui-ci en engendrant des microcoupures intempestives et aléatoires; etc.

Les figures du dessin annexé feront bien comprendre comment l'invention peut être réalisée.

La fig. 1 est un schéma électrique d'un mode de réalisation du dispositif de surveillance de microcoupures, conforme à l'invention;

les fig. 2a à 2j sont des diagrammes illustrant, en fonction du temps t, la forme des signaux électriques en différents points du schéma électrique de la fig. 1.

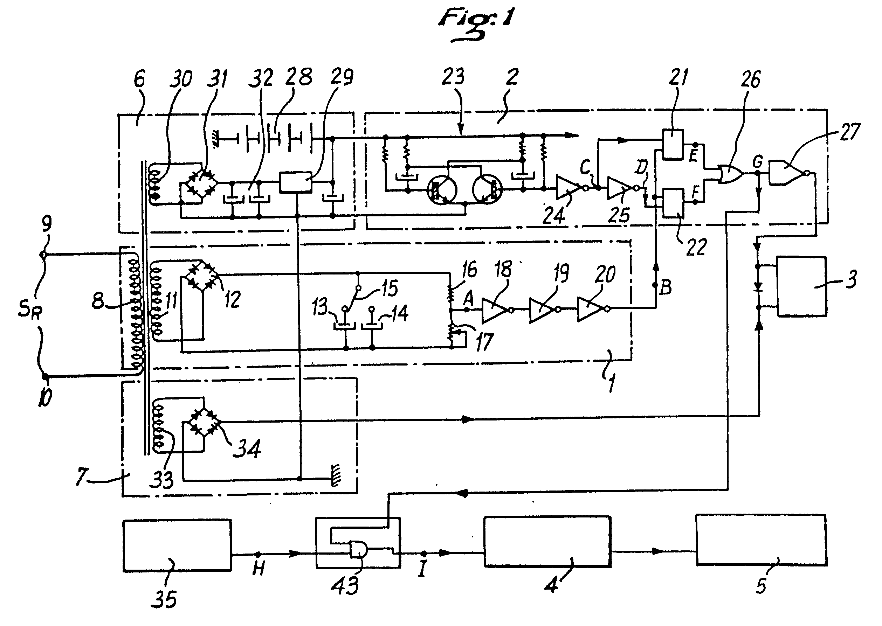

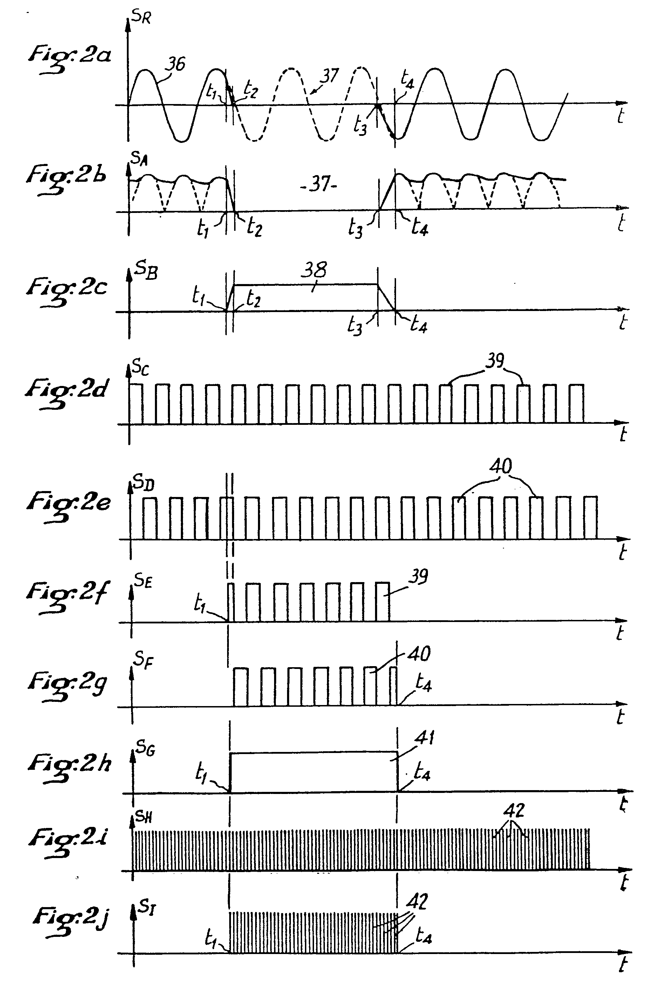

Le dispositif de détection et de mesure de microcoupures, conforme à l'invention et montré schématiquement sur la fig. 1, comporte un détecteur 1 fournissant son signal de sortie à un dispositif 2 d'adaptation au comptage, qui, lui-même, attaque un compteur de nombre de microcoupures 3 et un compteur de durée de microcoupures 4. Aux compteurs 3 et 4 peuvent être associés des afficheurs, imprimantes, etc., tels que celui illustré par la référence 5. Le dispositif selon l'invention comporte de plus une alimentation 6 chargée de fournir l'énergie électrique nécessaire pendant une microcoupure ainsi qu'un dispositif 7 de confirmation de microcoupures.

Le détecteur 1 comporte un primaire 8 aux bornes 9 et 10 duquel est appliqué le signal alternatif $S_R$ à surveiller et un secondaire 11, l'ensemble 8–11 formant un transformateur abaisseur. Le secondaire 11 applique la tension alternative qui le parcourt à un redresseur 12 à double alternance, associé à un filtre intégrateur 13 à 17. Ce filtre intégrateur comporte, d'une part, plusieurs condensateurs en parallèle 13, 14 pouvant être commutés à volonté à l'aide d'un commutateur 15, afin de faire varier la sensibilité dudit détecteur et, d'autre part, des résistances 16 et 17 montées en pont. Par exemple, le condensateur 13 et les résistances 16 et 17 sont choisis pour que leur constante de temps soit inférieure à 100 ms, tandis que la constante de temps formée par le condensateur 14 et les résistances 16 et 17 est supérieure à 100 ms. De plus, la résistance 17 est variable pour permettre de faire varier la tension au point milieu A du pont de résistance 16, 17. Cette tension au point A attaque l'entrée d'une porte logique à commutation rapide 18, elle-même suivie de deux portes logiques semblables 19 et 20 en cascade. Bien entendu, la résistance variable 17 permet d'ajuster le seuil de déclenchement de la porte 18. La sortie B de la porte 20 attaque le dispositif 2 d'adaptation au comptage. La pluralité des portes 18, 19, 20 en cascade a pour but de mettre le plus possible en forme le signal apparaissant au point A.

Le dispositif 2 d'adaptation au comptage comporte deux mémoires verrouillables 21 et 22, du type dit «latch», pourvues chacune d'une entrée de données, d'une entrée de déclenchement et d'une sortie. Dans ce type de mémoire, la transmission des données entre l'entrée de données et la sortie est verrouillée pendant la durée des signaux qui sont appliqués sur l'entrée de déclenchement, et qui, de plus, remettent à zéro ladite mémoire. Les deux mémoires 21 et 22 ont leurs entrées de données reliées en commun à la sortie B de la porte 20. Par ailleurs, les entrées de déclenchement des mémoires 21 et 22 sont alimentées à partir d'un multivibrateur 23, respectivement à travers une porte logique à commutation rapide 24 et à travers la cascade formée par la porte logique 24 et une autre porte logique à commutation rapide 25. L'agencement des portes 24 et 25 est tel que le signal à la sortie D de la porte 25 est décalé de 180° par rapport au signal à la sortie C de la porte 24. Les sorties E et F des mémoires 21 et 22 sont reliées aux entrées d'une porte logique 26 de type OU, dont la sortie est reliée, d'une part au compteur 4 de durée de microcoupures par une porte logique 43 de type ET, et, d'autre part au compteur 3 du nombre de microcoupures par un amplificateur 27.

Pendant les microcoupures, le multivibrateur 23 est alimenté par l'alimentation 6 qui comporte à cet effet une batterie 28 chargée par un chargeur 29, lui-même alimenté à partir d'un secondaire auxiliaire 30 du transformateur 8, 11, par l'intermédiaire d'un redresseur 31 à double alternance et d'un filtre 32.

Le dispositif 7 comporte un autre secondaire auxiliaire 33 du transformateur 8, 11, ainsi qu'un redresseur 34 à double alternance, relié au compteur 3.

La porte ET 43 comporte deux entrées, dont l'une est reliée à la sortie G de la porte 26 et l'autre à la sortie H d'un oscillateur 35.

Le fonctionnement du dispositif conforme à l'invention, montré par la fig. 1, est explicité ci-après, à l'aide des fig. 2a à 2j. A titre illustratif et non pas limitatif, on suppose que la fréquence du multivibrateur 23 est plusieurs fois supérieure à celle de la tension alternative $S_R$ à surveiller, alors que la fréquence de l'oscillateur 35 est plusieurs milliers de fois supérieure à celle de ladite tension $S_R$. Par exemple, la fréquence de la tension $S_R$ est 50 Hz, alors que les fréquences du multivibrateur 23 et de l'oscillateur 35 sont respectivement égales à 400 Hz et 1 MHz.

Comme l'indique la fig. 2a, le signal $S_R$ appliqué au primaire 8 est par exemple constitué par un signal sinusoïdal 36, sujet à des microcoupures 37, commençant à l'instant $t_1$ et finissant à l'instant $t_4$. Dans l'exemple représenté, la microcoupure 37 entraîne l'annulation de l'amplitude du signal 36 entre les instants $t_1$ et $t_2$, la nullité de cette amplitude entre les instants $t_2$ et $t_3$ et le rétablissement de ladite amplitude entre les instants $t_3$ et $t_4$.

Après être passé dans le transformateur 8, 11, avoir été redressé par le redresseur 12, puis avoir été intégré par l'intégrateur 13 à 17, le signal $S_R$ est transformé, au point A, dans le signal $S_A$ représenté sur la fig. 2b et constitué d'une tension ondulée, dans laquelle apparaît une interruption entre les instants $t_1$ et $t_4$.

Les flancs avant et arrière de cette interruption déclenchent les portes 18, 19 et 20, de sorte qu'au point B on obtient le signal $S_B$ de la fig. 2c, formé par un créneau 38 à flancs avant et arrière inclinés.

Le multivibrateur 23, constamment alimenté grâce au dispositif 6, émet un signal alternativ en créneaux rectangulaires, de sorte qu'aux points C et D sont constamment disponibles le signal $S_c$ de la fig. 2d et le signal $S_D$ de la fig. 2e, respectivement. Les créneaux rectangulaires 39 du signal $S_c$ et les créneaux rectangulaires 40 du signal $S_D$ sont identiques, mais déphasés de 180°.

Grâce aux mémoires 21 et 22, le créneau 38 appliqué au point B est échantillonné par les signaux $S_c$ et $S_D$. Les résultats de l'échantillonnage du créneau 38 par le signal $S_c$ et par le signal $S_D$ sont respectivement représentés par les signaux $S_E$ et $S_F$ des fig. 2f et 2g. L'addition desdits signaux $S_E$ et $S_F$ par la porte 26 engendre le signal $S_G$ de la fig. 2h, constitué d'un créneau rectangulaire parfait 41, commençant à l'instant $t_1$ et finissant à l'instant $t_4$.

Chaque créneau 41, qui constitue la représentation fidèle (au moins en ce qui concerne la durée) d'une microcoupure 37, peut être compté dans le compteur 3, après amplification par l'amplificateur 27. Le dispositif 7 fournit au compteur 3, une confirmation d'apparition de microcoupure.

Dans la porte 43, chaque créneau 41 est ensuite échantillonné par les impulsions 42 du signal $S_H$ de l'oscillateur 35 (voir la fig. 2i), de sorte que, à la sortie I de cette porte 43, on obtient le signal $S_I$ de

la fig. 2j. Le compteur 3 peut donc déterminer et emmagasiner la durée $t_4-t_1$ du créneau 41 et donc de l'interruption 37.

## Revendications

1. Dispositif pour la surveillance d'une tension électrique (36) sujette à des interruptions involontaires et momentanées (37) comportant des moyens (8 à 11) pour détecter une telle interruption (37), caractérisé en ce qu'il comporte des moyens (12 à 20) pour élaborer un signal électrique continu (38) dont la durée est représentative de celle de ladite interruption (37), des premiers moyens (21, 23, 24) pour échantillonner la durée dudit signal électrique (38) au moyen d'une première suite périodique ($S_C$) d'impulsions rectangulaires (39), des seconds moyens (22, 23, 24, 25) pour échantillonner la durée dudit signal électrique (38) au moyen d'une seconde suite périodique ($S_D$) d'impulsions rectangulaires (40), lesdites première et seconde suites périodiques étant telles que les impulsions de chacune d'elles correspondent aux intervalles entre les impulsions de l'autre suite, et des moyens (26) pour additionner les signaux d'échantillonnage ($S_E$ et $S_F$) apparaissant aux sorties desdits premiers et seconds moyens échantillonnant la durée dudit signal électrique (38), afin d'obtenir un signal (41) en créneau rectangulaire dont la durée correspond à celle de ladite interruption (37).

2. Dispositif selon la revendication 1, caractérisé en ce qu'il comporte des moyens de comptage (3) destinés à compter le nombre des signaux (41) en créneaux rectangulaires.

3. Dispositif selon l'une des revendications 1 ou 2, caractérisé en ce qu'il comporte des troisièmes moyens (35, 43) pour l'échantillonnage des signaux (41) en créneaux rectangulaires et des moyens de comptage (4) destinés à compter la durée de chacun desdits signaux (41) en créneaux rectangulaires.

4. Dispositif selon l'une quelconque des revendications 1 à 3, caractérisé en ce qu'il comporte des moyens d'alimentation électrique (6) à batterie tampon (28) pour l'alimentation d'au moins certains des moyens dudit dispositif pendant les interruptions (37) de la tension électrique (36).

5. Dispositif selon l'une quelconque des revendications 1 à 4, caractérisé en ce que les impulsions (30) de ladite première suite périodique sont identiques entre elles et sont identiques à celles (40) de ladite seconde suite, en ce que dans chaque suite deux impulsions consécutives sont séparées par un intervalle de durée égale à la durée d'une impulsion et en ce que les impulsions de l'une des suites sont déphasées de 180° par rapport à celles de l'autre suite.

6. Dispositif selon la revendication 5, caractérisé en ce que lesdits premiers et seconds moyens d'échantillonnage comportent un générateur d'impulsions unique (23, 24), associée à un inverseur (25).

7. Dispositif selon l'une quelconque des revendications 1 à 6, caractérisé en ce que lesdits premiers et seconds moyens d'échantillonnage comportent des mémoires verrouillables (21, 22), qui sont montées en parallèle à la sortie des moyens (12 à 20) élaborant ledit signal électrique continu (38) dont la durée est représentative de celle de ladite interruption (37) et dont les entrées de déclenchement reçoivent respectivement lesdites première et seconde suites périodiques d'impulsions rectangulaires.

8. Dispositif selon l'une quelconque des revendications 1 à 7, caractérisé en ce que les moyens (12 à 20) d'élaboration dudit signal électrique continu (38) dont la durée est représentative de celle ladite interruption (37) comportent au moins une porte logique (18, 19, 20) à commutation rapide.

9. Dispositif selon la revendication 8, caractérisé en ce que les moyens (12 à 20) d'élaboration dudit signal électrique continu (38) dont la durée est représentative de celle de ladite interruption (37) comportent des moyens (17) permettant d'ajuster le seuil de déclenchement de ladite porte logique (18) à commutation rapide.

10. Dispositif selon l'une quelconque des revendications 1 à 9, destiné à la surveillance d'une tension électrique alternative (36), caractérisé en ce que lesdits moyens (12 à 30) d'élaboration dudit signal électrique continu (38) dont la durée est représentative de celle de ladite interruption (37) comportent un redresseur (12) à double alternance et un circuit intégrateur (13 à 17) à constante de temps réglable.

## Patentansprüche

1. Vorrichtung zum Überwachen einer ungewollten und momentanen Unterbrechungen (37) unterworfenen elektrischen Spannung (36) mit Mitteln (8 bis 11) zur Feststellung einer derartigen Unterbrechung (37), dadurch gekennzeichnet, dass sie Mittel (12 bis 20) zum Erzeugen eines elektrischen Gleichspannungssignals (38), dessen Dauer der der Unterbrechung (37) entspricht, erste Mittel (21, 23, 24) zum Zerlegen der Dauer des elektrischen Signals (38) mittels einer ersten periodischen Folge ($S_C$) von Rechteckimpulsen (39), zweite Mittel (22, 23, 24, 25) zum Zerlegen der Dauer des elektrischen Signals (38) mittels einer zweiten periodischen Folge ($S_D$) von Rechteckimpulsen (40), wobei die erste und zweite periodische Folge derart gestaltet sind, dass die Impulse jeder von ihnen in den Intervallen der anderen Folge auftreten, sowie Mittel (26) zum Addieren der Zerlegungssignale ($S_E$ und $S_F$) umfasst, die an den Ausgängen der ersten und zweiten, die Dauer des elektrischen Signals (28) zerlegenden Mittel erscheinen, um ein Signal (41) in Rechteckform zu liefern, dessen Dauer der der Unterbrechung (37) entspricht.

2. Vorrichtung nach Anspruch 1, dadurch gekennzeichnet, dass sie Mittel (3) zum Zählen der Anzahl der Signale (41) in Rechteckform umfasst.

3. Vorrichtung nach einem der Ansprüche 1 oder 2, dadurch gekennzeichnet, dass sie dritte Mittel (35, 43) zum Zerlegen der Signale (41) in Rechteckform und Mittel (4) zum Zählen der Dauer jedes der Signale (41) in Rechteckform umfasst.

4. Vorrichtung nach einem der Ansprüche 1 bis 3, dadurch gekennzeichnet, dass sie Mittel zur elektrischen Versorgung (6) mit einer Pufferbatterie (28) zum Versorgen wenigstens einiger der Mittel der Vorrichtung während der Unterbrechungen (37) der elektrischen Spannung umfasst.

5. Vorrichtung nach einem der Ansprüche 1 bis 4, dadurch gekennzeichnet, dass die Impulse (30) der ersten periodischen Folge untereinander identisch sind und mit denen (40) der zweiten periodischen Folge identisch sind, dass in jeder Folge zwei aufeinanderfolgende Impulse durch ein Intervall von gleicher Dauer wie die Dauer eines Impulses getrennt sind und dass die Impulse einer der Folgen um 180° gegenüber denen der anderen Folge phasenverschoben sind.

6. Vorrichtung nach Anspruch 5, dadurch gekennzeichnet, dass die ersten und zweiten Mittel zum Zerlegen einen einzigen, mit einem Inverter (25) verbundenen Impulsgenerator (23, 24) umfassen.

7. Vorrichtung nach einem der Ansprüche 1 bis 6, dadurch gekennzeichnet, dass die ersten und zweiten Mittel zum Zerlegen verriegelbare Speicher (21, 22) umfassen, die parallel am Ausgang der das elektrische Gleichspannungssignal (38) erzeugenden Mittel geschaltet sind, dessen Dauer der der Unterbrechung (37) entspricht, und deren Auslösungseingänge jeweils die erste bzw. die zweite periodische Folge von Rechteckimpulsen empfangen.

8. Vorrichtung nach einem der Ansprüche 1 bis 7, dadurch gekennzeichnet, dass die Mittel (12 bis 20) zum Erzeugen des elektrischen Gleichspannungssignals (38), dessen Dauer der der Unterbrechung (37) entspricht, wenigstens eine logische Torschaltung (18, 19, 20) mit schneller Umschaltung umfassen.

9. Vorrichtung nach Anspruch 8, dadurch gekennzeichnet, dass die Mittel (12 bis 20) zum Erzeugen des elektrischen Gleichspannungssignals (38), dessen Dauer der der Unterbrechung (37) entspricht, Mittel (17) umfassen, die die Einstellung der Auslösungsschwelle der logischen Torschaltung (18) mit schneller Umschaltung erlauben.

10. Vorrichtung nach einem der Ansprüche 1 bis 9 zum Überwachen einer elektrischen Wechselspannung (36), dadurch gekennzeichnet, dass die Mittel (12 bis 20) zum Erzeugen des elektrischen Gleichspannungssignals (38), dessen Dauer der der Unterbrechung (37) entspricht, einen Vollbrückengleichrichter (12) und einen Integrationskreis (13 bis 17) mit einstellbarer Zeitkonstante umfassen.

## Claims

1. Device for the supervision of an electrical voltage (36) being subject to unintentional, momentary interruptions (37), comprising means (8 to 11) for detecting said interruption (37), characterized in that it comprises means (12 to 20) for generating a continuous electrical signal (38), the duration of which is representative of that of said interruption (37), first means (21, 23, 24) for sampling the duration of said electrical signal (38) by means of a first periodical series ($S_C$) of rectangular impulses (39), second means (22, 23, 24, 25) for sampling the duration of said electrical signal (38) by means of a second periodical series ($S_D$) of rectangular impulses (40), said first and second periodical series being such that the impulses of each of them correspond to the intervals between the impulses of the other series, and means (26) for adding the sampling signals ($S_E$ and $S_F$) appearing at the outputs of said first and second means sampling the duration of said electrical signal (38), in order to obtain a rectangular signal (41), the duration of which corresponds to that of said interruption (37).

2. Device according to claim 1, characterized in that it comprises counting means (3) for counting the number of rectangular signals (41).

3. Device according to one of claims 1 or 2, characterized in that it comprises third means (35, 43) for sampling the rectangular signals (41) and counting means (4) for counting the duration of each of said rectangular signals (41).

4. Device according to any one of claims 1 to 3, characterized in that it comprises electrical supply means (6) with buffer battery (28) for supplying at least some of the means of said device during the interruptions (37) of the electrical voltage (36).

5. Device according to any one of claims 1 to 4, characterized in that the impulses (30) of said first periodical series are identical one with the other and are identical with those (40) of said second series, in that, in each series, two consecutive impulses are separated by an interval, the duration of which is equal to the duration of an impulse and in that the impulses of one of the series are out of phase of 180° with respect to those of the other series.

6. Device according to claim 5, characterized in that said first and second sampling means comprise a single impulse generator (23, 24), associated with an inverter (25).

7. Device according to any one of claims 1 to 6, characterized in that said first and second sampling means comprise lockable memories (21, 22), which are mounted in parallel at the output of the means (12 to 20) generating said continuous electrical signal (38), the duration of which is representative of that of said interruption (37) and the triggering inputs of which receive said first and second periodical series of rectangular impulses, respectively.

8. Device according to any one of claims 1 to 7, characterized in that the means (12 to 20) for generating said continuous electrical signal (38), the duration of which is representative of that of said interruption (37) comprise at least one quick switching logical gate (18, 19, 20).

9. Device according to claim 8, characterized in that the means (12 to 20) for generating said continuous electrical signal (38), the duration of which is representative of that of said interruption (37) comprise means (17) being able to adjust the triggering threshold of said quick switching logical gate (18).

10. Device according to any one of claims 1 to 9, for the supervision of an alternating electrical voltage (36), characterized in that said means (12 to 20) for generating said continuous electrical signal (38), the duration of which is representative of that of said interruption (37) comprise a double alternation rectifier (12) and an adjustable time constant integrator circuit (13 to 17).

Fig. 1

0156727

Fig.2a

Fig.2b

Fig.2c

Fig.2d

Fig.2e

Fig.2f

Fig.2g

Fig.2h

Fig.2i

Fig.2j